# EUROPÄISCHE PATENTSCHRIFT

(11) **EP 3 763 176 B1**
(45) Veröffentlichungstag und Bekanntmachung des Hinweises auf die Patenterteilung: **16.03.2022**
(21) Anmeldenummer: 19707785.2
(22) Anmeldetag: 26.02.2019
(51) Int. Cl.: H05K 7/14, G21D 3/00

(54) **MODULAR AUFGEBAUTE EINSCHUBWANDLEREINHEIT SOWIE LEITTECHNIKSTROMVERSORGUNGSSYSTEM FÜR EIN KERNKRAFTWERK**
MODULARLY CONSTRUCTED PUSH-IN TRANSDUCER UNIT AND INSTRUMENTATION AND CONTROL POWER SUPPLY SYSTEM FOR A NUCLEAR POWER PLANT
ENSEMBLE CONVERTISSEUR ENFICHABLE DE CONCEPTION MODULAIRE ET SYSTÈME D'ALIMENTATION EN COURANT DE COMMANDE DE PROCESSUS POUR UNE CENTRALE NUCLÉAIRE

(30) Priorität: 07.03.2018 DE 102018105173
(43) Veröffentlichungstag der Anmeldung: 13.01.2021
(73) Patentinhaber: Framatome GmbH, 91052 Erlangen (DE)
(72) Erfinder: SAHIN, Hakan, 91052 Erlangen (DE); BRAND, Martin, 91052 Erlangen (DE); KOWACZEK, Christian, 91052 Erlangen (DE); KORYÜREK, Ibrahim, 91052 Erlangen (DE); GHEBRESELASSIE, Ermiyas, 91052 Erlangen (DE)
(74) Vertreter: Lavoix
(86) Internationale Anmeldenummer: PCT/EP2019/054707
(87) Internationale Veröffentlichungsnummer: WO 2019/170471

(56) Entgegenhaltungen:
- EP-A1- 2 600 489
- DE-U1-202006 008 138
- US-A1- 2013 322 016

## Beschreibung

Die Erfindung betrifft eine modular aufgebaute Einschubwandlereinheit für einen Schaltschrank eines Versorgungssystems eines Kernkraftwerks. Ferner betrifft die Erfindung ein Leittechnikstromversorgungssystem für ein Kraftwerk.

US 2013/322016 A1 beschreibt ein Energiemanagementsystem.

EP 2 600 489 A1 beschreibt ein Verfahren zur Notstromversorgung für ein Kernkraftwerk.

Heutzutage erfolgt in sicherheitsrelevanten Notstromanlagen eines Kernkraftwerks die Stromversorgung der betrieblichen Leittechnik und die der Sicherheitsleittechnik zumeist redundant über verschiedene Schaltschrankkombinationen mit unterschiedlichen Schaltschrankkonstruktionen und entsprechenden Spannungswandlern, beispielsweise AC/DC und DC/DC. Hierbei ist es jedoch notwendig, dass die unterschiedlichen Systeme gemäß ihrer verschiedenen Funktions- bzw. Sicherheitsklassen voneinander elektrisch getrennt sind.

Üblicherweise wird dies dadurch sichergestellt, dass jeweils einzelne Schaltschrankkombinationen pro System, pro Redundanz sowie entsprechender Sicherheitsklasse vorgesehen sind, also in konservativer Weise. Dies führt jedoch zu einem erhöhten Planungs-, Design- und Qualifizierungsaufwand. Zudem ist der Platzbedarf in den elektrischen Betriebsräumen entsprechend hoch, da sehr viele Schaltschränke vorgesehen sind.

Die Aufgabe der Erfindung ist es, eine einfache und platzsparende Möglichkeit vorzusehen, um ein Versorgungssystem für ein Kernkraftwerk bereitstellen zu können und trotzdem die Anforderungen an Trennung und Unabhängigkeit einzuhalten.

Die Aufgabe wird erfindungsgemäß durch eine modular aufgebaute Einschubwandlereinheit gemäß Anspruch 1 gelöst.

Ansprüche 2 bis 9 beschreiben bevorzugte Ausführungsformen der Einschubwandlereinheit.

Ferner wird die Aufgabe erfindungsgemäß gelöst durch ein Leittechnikstromversorgungssystem für ein Kernkraftwerk gemäß Anspruch 10.

Ansprüche 11 bis 15 beschreiben bevorzugte Ausführungsformen des Leittechnikstromversorgungssystems.

Der Grundgedanke der Erfindung ist es, eine modulare Plattform innerhalb des einzigen Schaltschranks bereitzustellen, der Teil des Versorgungssystems des Kernkraftwerks ist, wobei die modulare Plattform eine galvanische Trennung und Separation der modular aufgebauten Einschubwandlereinheiten bereitstellen kann. Die Einschubwandlereinheit ist beispielsweise nur als Verteiler im Leittechnikstromversorgungssystem vorgesehen, wobei er aufgrund der Gruppe von Sicherungen zur Absicherung beiträgt.

Die modular aufgebaute Einschubwandlereinheit kann in einen Schaltschrank eingesetzt und in diesem befestigt werden. In die im Schaltschrank eingesetzte Einschubwandlereinheit kann dann ein Einschubwandler oder mehrere Einschubwandler eingeschoben werden.

Beispielsweise sind wenigstens zwei modular aufgebaute Einschubwandlereinheiten vorgesehen, die in einem ersten Betriebsmodus des Versorgungssystems galvanisch getrennt voneinander sind und in einem zweiten Betriebsmodus des Versorgungssystems elektrisch miteinander verbunden sind. Hierdurch können mehrsträngige Versorgungssysteme mit Unterteilung in verschiedene Sicherheits- bzw. Funktionsklassen ermöglicht werden (erster Betriebsmodus). Aufgrund der galvanischen Trennung der jeweils modular aufgebauten Einschubwandlereinheiten, insbesondere des mechanischen Separationskonzepts, können die Anforderungen an die Trennung gemäß IEEE 384 eingehalten und eine Teilung der Versorgungssysteme umgesetzt werden.

Ebenso ist es möglich, die modular aufgebauten Einschubwandlereinheiten der modularen Plattform elektrisch miteinander zu verbinden (zweiter Betriebsmodus), sodass die den Einschubwandlereinheiten entsprechend zugeordneten Versorgungsleistungen zusammengeführt werden.

Aufgrund der modularen Plattform innerhalb des Schaltschranks kann dieser entsprechend frei konfiguriert werden. Beispielsweise kann bei mehr als zwei modular aufgebauten Einschubwandlereinheiten auch vorgesehen sein, dass zwei Einschubwandlereinheiten miteinander elektrisch verbunden sind und eine dritte Einschubwandlereinheit hierzu galvanisch getrennt ist.

Die modular aufgebaute Einschubwandlereinheit kann vorkonfektioniert sein, sodass sie sich als ein Halbzeug lagern lässt und nur noch in einen bestehenden Schaltschrank eingesetzt und daran befestigt werden muss, beispielsweise mittels Schrauben. Hierdurch ergeben sich schnelle Fertigungszeiten des Versorgungssystems, da der modular aufgebaute Schaltschrank nur noch entsprechend bestückt werden muss.

Da die Einschubwandlereinheit ausgebildet ist, in einem Leittechnikstromversorgungssystem eines Kernkraftwerks eingesetzt zu werden, ist die Einschubwandlereinheit ausgelegt bzw. ausgebildet, Ströme bis zu 180 A bereitzustellen.

Aufgrund der modularen Bauweise können die verwendeten Einschubwandler als AC/DC-, DC/DC- bzw. DC/AC- Einschubwandler ausgebildet sein, mit denen sich eine Wandlung von 230/400 V AC oder 220 V DC auf 24 V Gleichspannung, 220 V Gleichspannung oder 230 V/400 V Wechselspannung realisieren lässt.

Insbesondere ist der Einschubwandler ausgebildet bzw. dafür ausgelegt, in einer vorgesehenen Einschubwandlereinheit (Etage) eines Schaltschranks eingeschoben zu werden.

Generell kann der Schaltschrank mehrere Etagen umfassen, die jeweils eingerichtet sind, eine Einschubwandlereinheit aufzunehmen.

Ferner kann jede Einschubwandlereinheit ausgebildet sein, wenigstens einen Einschubwandler aufzunehmen, insbesondere drei Einschubwandler.

Die Einschubwandlereinheit kann zur Aufnahme des wenigstens einen Einschubwandlers einen entsprechenden Aufnahmeschacht aufweisen, in den sich der wenigstens eine Einschubwandler einschieben lässt.

Ein Aspekt sieht vor, dass wenigstens ein galvanisch getrennter Einschubwandler vorgesehen ist, insbesondere wobei der wenigstens eine Einschubwandler eine belastungsabhängige regressive Kennlinie hat. Hierdurch lässt sich eine spezielle Regelcharakteristik implementieren, wodurch unter anderem auf programmierbare Bauteile bzw. eine übergeordnete Steuerung zur Lastaufteilung verzichtet werden kann. Ein durch Software verursachter Ausfall lässt sich so wirkungsvoll verhindern. Dies wird auch als "Cyber Security" bezeichnet. Des Weiteren wird der Aufwand für die Qualifizierung reduziert, da keine programmierbare Bauteile für die Funktion nötig sind und somit keine Softwarequalifizierung erforderlich ist.

Mit anderen Wort kann der Einschubwandler bzw. das Leittechnikstromversorgungssystem als selbstregulierend bezeichnet werden.

Insbesondere ist eine Redundanz- bzw. Parallelschaltung ohne übergeordnete Steuerung möglich.

Insofern ist eine funktionale Unabhängigkeit der einzelnen Einschubwandlereinheiten im Leittechnikstromversorgungssystem geschaffen.

Ein weiterer Aspekt sieht vor, dass zumindest der Ausgang der Einschubwandler durch Steckkontakte ausgebildet ist. Hierdurch lässt sich der modular aufgebaute Einschubwandler in einfacher Weise einbauen bzw. entnehmen, da hierzu der Einschubwandler lediglich in den Schaltschrank, insbesondere die entsprechend vorgesehene modular aufgebaute Einschubwandlereinheit, eingeschoben bzw. eingesteckt wird. Beispielsweise müssen nur die Befestigungsschrauben angezogen bzw. gelöst werden.

Gemäß einem weiteren Aspekt ist die Sammelschiene mehrteilig ausgebildet, insbesondere dreiteilig. Über die mehreren Teile der Sammelschiene können unterschiedliche Funktionen realisiert werden, beispielsweise eine Lastsammeischiene, eine Rückleiterschiene bzw. eine Entkopplungsschiene.

Gemäß einer Ausführungsform umfasst die Einschubwandlereinheit drei galvanisch getrennte Einschubwandler. Die drei Einschubwandler können entweder einer gemeinsamen Phase oder jeweils einer Phase eines dreiphasigen Anschlusses zugeordnet sein. Insofern ist die Einschubwandlereinheit ausgebildet, ein- oder dreiphasigen Strom zu verarbeiten.

Ein weiterer Aspekt sieht vor, dass Einschubwandlereinheit ein Luftleitblech und/oder eine Entkopplungsdiode umfasst, insbesondere wobei die Entkopplungsdiode mit dem Luftleitblech thermisch gekoppelt ist. Über das Luftleitblech kann ein vorhandener Luftstrom entsprechend gelenkt werden, beispielsweise wird über das Luftleitblech ein durch die Elektronik strömender Luftstrom in Richtung Strömungsauslass des Schaltschranks gelenkt. Der Luftstrom kann durch eine Lüftung erzeugt werden, die dem Schaltschrank, insbesondere dem Einschubwandler, zugeordnet ist, beispielsweise im Schaltschrank implementiert ist.

Insbesondere lässt sich über das Luftleitblech der Luftstrom so lenken, dass die Entkopplungsdiode gekühlt wird, die eine gegenseitige Beeinflussung von Einschubwandlern verhindert. Vorzugsweise ist die Entkopplungsdiode hierzu mit dem Luftleitblech thermisch gekoppelt, sodass eine entsprechende Kühlung der Entkopplungsdiode gewährleistet ist, beispielsweise über ein Montageblech, das direkt am Luftleitblech befestigt ist oder indem die Entkopplungsdiode direkt am Luftleitblech angeordnet ist.

Gemäß einer Ausführungsform weist die Einschubwandlereinheit mindestens eine Lüfterbaugruppe auf, insbesondere wobei die Lüfterbaugruppe separat entnehmbar und/oder adaptiv geregelt ist und/oder einen Temperaturfühler umfasst. Demnach wird der Luftstrom, der über das Luftleitblech geleitet wird, von dem Einschubwandler selbst erzeugt, nämlich der entsprechenden Lüfterbaugruppe, die einen Lüfter umfasst. Der Lüfter der Lüfterbaugruppe kann die Luft ansaugen und dann über die vorgesehenen Elektronikkomponenten drücken, beispielsweise durch den Einschubwandler. Die Lüfterbaugruppe kann separat zum Rest der Einschubwandlereinheit entnehmbar sein, indem sie beispielsweise am Rahmen angeordnet ist. Hierdurch ist ein Defekt einfach behebbar. Die Lüfterbaugruppe lässt sich zudem direkt über den Einschubwandler mit Energie versorgen.

Über den Temperaturfühler kann die Kühlkörpertemperatur der Einschubwandlereinheit, insbesondere des Einschubwandlers, erfasst werden. Aufgrund der erfassten Temperatur kann die Lüfterbaugruppe adaptiv geregelt werden (adaptive Regelung der Lüfterbaugruppe), da die Drehzahl des Lüfters der Lüfterbaugruppe gesenkt wird, wenn keine starke Erwärmung erfasst worden ist. Insofern stellt die adaptive Regelung sicher, dass die Geräuschentwicklung im Schaltschrank deutlich reduziert ist.

Beispielsweise umfasst die Einschubwandlereinheit eine Sicherungseinheit, insbesondere wobei die Lastklemme und/oder die Sammelschiene an der Sicherungseinheit angeordnet sind bzw. ist. In der Sicherungseinheit können Lastsicherungen vorgesehen sein, die zur elektrischen Absicherung dienen. Ferner kann die Sicherungseinheit einen Sicherungskasten umfassen, der gleichzeitig als Stütze für die Lastklemme und/oder die Sammelschiene dient. Hierdurch ergibt sich ein kompakter Aufbau der modular aufgebauten Einschubwandlereinheit.

Gemäß einem weiteren Aspekt umfasst die Einschubwandlereinheit eine Überwachungseinheit, die eingerichtet ist, einen Kurzschluss, eine Überspannung und/oder eine Unterspannung zu erkennen, insbesondere wobei die Überwachungseinheit eingangsseitig eine Überspannung und/oder eine Unterspannung und ausgangsseitig einen Kurzschluss, eine Überspannung und/oder eine Unterspannung überwacht.

Die Überwachungseinheit kann in einem, insbesondere in jedem, der Einschubwandler implementiert sein.

Insofern kann der Einschubwandler eine Überwachungseinheit umfassen, die eingerichtet ist, einen Kurzschluss, eine Überspannung und/oder eine Unterspannung zu erkennen.

Die Überwachungseinheit kann mehrteilig ausgebildet sein, sodass beispielsweise eine eingangsseitige Über- bzw. Unterspannungsüberwachung sowie eine ausgangsseitige Über- bzw. Unterspannungs- und Kurzschlussüberwachung vorgesehen sind.

Beispielsweise kann ein Shunt-Widerstand vorgesehen sein, über den die Einschubwandlereinheit entsprechend überwacht werden kann. Der Shunt-Widerstand kann der Sammelschiene zugeordnet sein.

Ein weiterer Aspekt sieht vor, dass im Schaltschrank bis zu vier Einspeisungen, bis zu vier Gruppen von Lastanschlüssen und/oder bis zu vier modular aufgebaute Einschubwandlereinheiten vorhanden sind. Der Schaltschrank kann entsprechend mit vier modular aufgebauten Einschubwandlereinheiten bestückt sein. Hierdurch ergibt sich, dass ein viersträngiger Systemaufbau des Leittechnikstromversorgungssystems möglich ist, wie er in Kernkraftwerken üblicherweise gefordert ist. Pro Einschubwandlereinheit lassen sich so Ströme bis zu 180 A verarbeiten, wobei die vier Einschubwandlereinheiten miteinander elektrisch gekoppelt werden können, sodass eine gemeinsame Spannungsversorgung mit einem Gesamtstrom von 720 A möglich ist. Die vier separaten Einspeisungen können jeweils drei- bzw. einphasig sein. An den bis zu vier Gruppen von Lastanschlüssen können beispielsweise jeweils bis zu 7 große oder bis zu 10 kleine Lasten (Lastgruppen) angeschlossen werden, sodass insgesamt bis zu 40 Lasten pro Schaltschrank angeschlossen werden können.

Ein weiterer Aspekt sieht vor, dass der Schaltschrank einen Kabelkanalaufnahmeraum und/oder eine Schaltschranktür aufweist, an der eine Spannungs- und/oder Stromanzeige vorgesehen ist. In dem Kabelkanalaufnahmeraum können bis zu 28 Kabel eines großen Querschnitts, beispielsweise Kabel mit einem Querschnitt von 35 mm², oder bis zu 40 Kabel mit einem kleineren Querschnitt aufgenommen werden. Die von außen ersichtliche Spannungs- bzw. Stromanzeige an der Schaltschranktür ermöglicht es, dass ein Bediener des Versorgungssystems die relevanten Systemdaten direkt erfassen kann.

Insbesondere ist wenigstens ein elektrischer Zwischenspeicher vorgesehen, beispielsweise eine Batterie. Der elektrische Zwischenspeicher kann in einem separaten Schaltschrank angeordnet sein. Die Batterie kann über die wenigstens eine Einspeisung mit aufgeladen werden. Zudem kann die in der Batterie zwischengespeicherte Energie über den zumindest einen Lastanschluss abgeben werden, sodass eine unterbrechungsfreie Stromversorgung garantiert ist.

Beispielsweise ist die zumindest eine modular aufgebaute Einschubwandlereinheit des Leittechnikstromversorgungssystems gemäß einer Einschubwandlereinheit der zuvor genannten Art ausgebildet. Die oben genannten Vorteile ergeben sich in analoger Weise.

Ein weiterer Aspekt sieht vor, dass das Leittechnikstromversorgungssystem Teil einer mehrstängigen Notstromanlage eines Kernkraftwerks ist. Beispielsweise handelt es sich um eine modulare Leittechnikstromversorgung, die mehrstängig ist.

Weitere Vorteile und Eigenschaften der vorliegenden Erfindung ergeben sich aus der nachfolgenden Beschreibung und den Zeichnungen, auf die Bezug genommen wird. In den Zeichnungen zeigen:
- Figur 1 eine perspektivische Ansicht eines erfindungsgemäßen Leittechnikstromversorgungssystems für ein Kraftwerk,
- Figur 2 eine weitere perspektivische Ansicht des Leittechnikstromversorgungssystems aus Figur 1,
- Figur 3 eine schematische Einstrichdarstellung des erfindungsgemäßen Leittechnikstromversorgungssystems,
- Figur 4 eine perspektivische Ansicht einer erfindungsgemäßen Einschubwandlereinheit,
- Figur 5 eine weitere perspektivische Ansicht der Einschubwandlereinheit aus Figur 4, und
- Figur 6 ein schematisches Blockschaltbild eines Einschubwandlers, der in einer erfindungsgemäßen Einschubwandlereinheit eingeschoben werden kann.

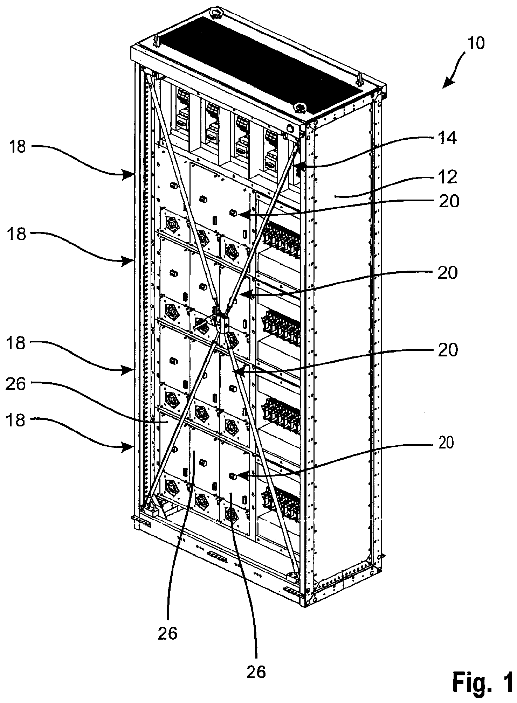

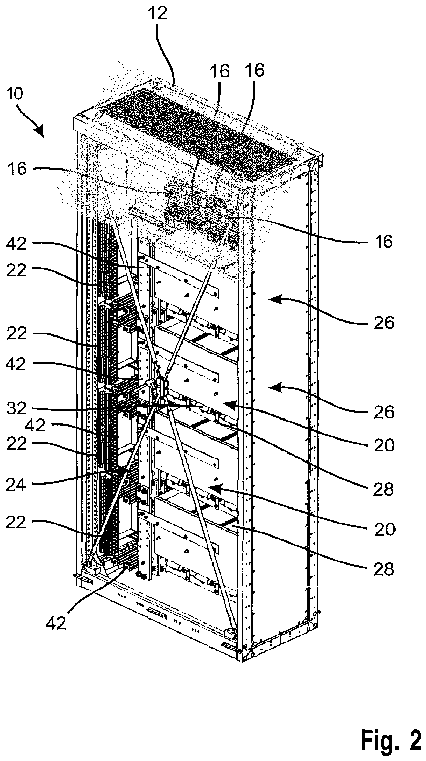

In den Figuren 1 und 2 ist ein Leittechnikstromversorgungssystem 10 für ein Kernkraftwerk gezeigt, welches in einem Schaltschrank 12 ausgebildet ist.

Der Schaltschrank 12 ist in Figur 1 perspektivisch von vorne und in Figur 2 perspektivisch von hinten gezeigt, wobei der Schaltschrank 12 in der gezeigten Ausführungsform fünf Ebenen umfasst.

In der ersten Ebene von oben ist eine Einspeisezeile 14 vorgesehen, die vier Einspeisungen 16 umfasst, wie aus der Figur 2 hervorgeht. Die vier Einspeisungen 16 können voneinander getrennt sein. Die Einspeisungen 16 stellen dem Leittechnikstromversorgungssystem 10 entsprechend elektrische Leistung zur Verfügung. Aufgrund der vier Einspeisungen 16 kann das Leittechnikstromversorgungssystem 10 auch als mehrsträngiges Leittechnikstromversorgungssystem 10 bezeichnet werden, insbesondere als viersträngiges Leittechnikstromversorgungssystem 10, wie dies bei Kernkraftwerken üblicherweise der Fall ist.

Insbesondere handelt es sich bei dem Leittechnikstromversorgungssystem 10 um eine mehrsträngige Versorgung leittechnischer Verbraucher. Das Leittechnikstromversorgungssystem 10 kann Teil einer mehrsträngigen Notstromanlage eines Kernkraftwerks sein.

Die Einspeisezeile 14, die in der in den Figuren 1 und 2 gezeigten Ausführungsform, oben angeordnet ist, kann alternativ auch am Boden des Schaltschranks 12 vorgesehen sein.

Des Weiteren umfasst der Schaltschrank 12 in der gezeigten Ausführungsform vier Etagen 18, in denen jeweils eine modular aufgebaute Einschubwandlereinheit 20 angeordnet ist.

Folglich können die Einschubwandlereinheiten 20 in die entsprechenden Etagen 18 einfach eingesetzt und im Schaltschrank 12 befestigt werden, um die gewünschte Funktionalität des Versorgungssystems 10 zu erhalten.

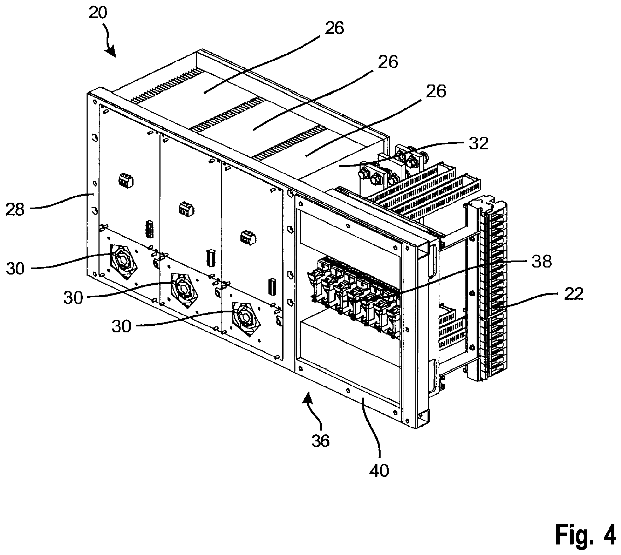

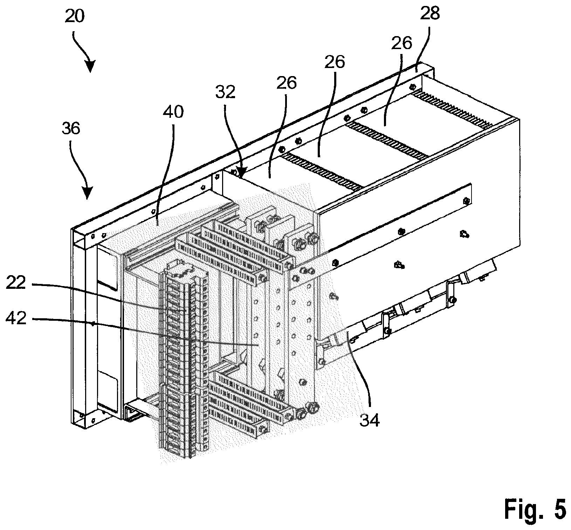

Die Einschubwandlereinheiten 20 sind in den Figuren 4 und 5 genauer gezeigt, auf die nachfolgend noch Bezug genommen wird.

Des Weiteren umfasst das Leittechnikstromversorgungssystem 10 mehrere Lastanschlüsse 22, die in der gezeigten Ausführungsform jeweils an den Einschubwandlereinheiten 20 selbst ausgebildet sind, insbesondere an deren Rückseiten. Die Lastanschlüsse 22 können auch als Lastklemmen bezeichnet werden.

An den Lastanschlüssen 22 können elektrische Lasten angeschlossen werden, die vom Versorgungssystem 10 mit elektrischer Energie versorgt werden sollen.

Im Schaltschrank 12 ist zudem ein Kabelkanalaufnahmeraum 24 vorgesehen, in dem die jeweiligen Anschlusskabel abgelegt und befestigt werden können.

Aus den Figuren 1 und 2 geht zudem bereits hervor, dass die jeweiligen Einschubwandlereinheiten 20 mehrere galvanisch getrennte Einschubwandler26 umfassen. In der gezeigten Ausführungsform sind jeweils drei galvanisch getrennte Einschubwandler26 pro Einschubwandlereinheit 20 und somit pro Etage 18 vorgesehen. Insofern lassen sich dreiphasige Stromleitungen anbringen.

Alternativ kann auch vorgesehen sein, dass eine Einschubwandlereinheit 20 keinen Einschubwandler 26, nur einen galvanisch getrennten Einschubwandler26 oder zwei galvanisch getrennte Einschubwandler 26 aufweist.

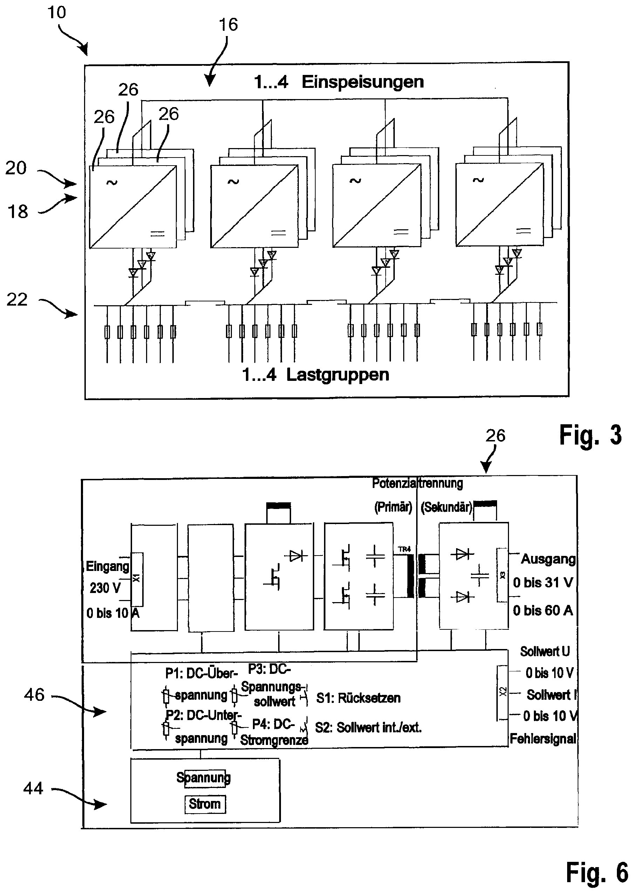

In Figur 3 ist das Leittechnikstromversorgungssystem 10 in einer schematisch vereinfachten Darstellung gezeigt. Hieraus geht hervor, dass die vier Ebenen, denen die Etagen 18 zugeordnet sind, mit ein bis vier Einspeisungen 16 versorgt werden können.

Jede der vier Etagen 18 ist mit einer Einschubwandlereinheit 20 bestückt, die bis zu drei galvanisch getrennte Einschubwandler26 umfasst, insbesondere für jede Phase eines Dreiphasenanschlusses. Zusätzlich kann ein einphasiger Anschluss aller drei Einschubwandler 26 realisiert werden.

Die Einschubwandlereinheiten 20 sind wiederum über die Lastanschlüsse 22 mit mehreren Lastgruppen gekoppelt, beispielsweise ein bis vier Lastgruppen, wobei jede Lastgruppe mehrere Lasten umfassen kann, insbesondere bis zu zehn Lasten.

In den Figuren 4 und 5 ist eine modular aufgebaute Einschubwandlereinheit 20 detailliert gezeigt.

Hieraus geht hervor, dass die Einschubwandlereinheit 20 einen Rahmen 28 umfasst, der die drei galvanisch getrennten Einschubwandler26 trägt.

Ferner geht aus den Figuren hervor, dass wenigstens eine Lüfterbaugruppe 30 vorgesehen ist, insbesondere eine Lüfterbaugruppe 30 pro galvanisch getrenntem Einschubwandler26, sodass drei Lüfterbaugruppen 30 in einer Einschubwandlereinheit 20 vorgesehen sind, die jeweils unabhängig voneinander sind.

Die Lüfterbaugruppen 30 sind jeweils unterhalb der galvanisch getrennten Einschubwandler26 angeordnet, wobei die Lüfterbaugruppen 30 einen Temperaturfühler umfassen, der die Temperatur des zugeordneten Einschubwandlers26 erfasst.

In Abhängigkeit von der Temperatur des Einschubwandlers26 regelt die Lüfterbaugruppe 30 die Lüfterdrehzahl, sodass eine adaptive Kühlung der Elektronikkomponenten bzw. adaptive Regelung der Lüfterbaugruppe 30 gegeben ist.

Des Weiteren umfasst die Einschubwandlereinheit 20 jeweils ein Luftleitblech 32, das am Rahmen 28 angeordnet ist. Mit dem Luftleitblech 32 ist je Einschubwandler 26 eine Entkopplungsdiode 34 thermisch gekoppelt, insbesondere über ein Blechteil am Luftleitblech 32 derart montiert, dass es thermisch mit dem Luftleitblech 32 gekoppelt ist.

Die Lüfterbaugruppen 30 erzeugen einen Luftstrom, indem sie Luft ansaugen. Die angesaugte Luft wird durch den jeweils zugeordneten Einschubwandler26 gedrückt. Dabei strömt die Luft über die entsprechende Entkopplungsdiode 34 der nächsten Etage im Schaltschrank 12.

Das Luftleitblech 32 der darüber angeordneten Einschubwandlereinheit 20 fungiert dann als Ableitung für den Luftstrom, sodass der dann erwärmte Luftstrom durch eine hier nicht dargestellte Schaltschranktür nach außen befördert wird.

Da im Schaltschrank 12 mehrere Einschubwandlereinheiten 20 vorgesehen sind, insbesondere eine Einschubwandlereinheit 20 mit bis zu drei Einschubwandlern 26 pro Etage 18, können auch bis zu drei Entkopplungsdioden 34 pro Etage 18 vorgesehen sein.

Des Weiteren umfasst die Einschubwandlereinheit 20 eine Sicherungseinheit 36, die mehrere Lastsicherungen 38 umfasst. Die Sicherungseinheit 36 weist des Weiteren einen Sicherungskasten 40 auf, der in dem Rahmen 28 eingesetzt ist, insbesondere am Rahmen 28 befestigt ist.

Der Sicherungskasten 40 dient gleichzeitig als Stütze für die Lastanschlüsse 22 bzw. Lastklemmen sowie eine Sammelschiene 42, die jeweils rückseitig an der Einschubwandlereinheit 20 angeordnet sind, wie aus der Figur 5 hervorgeht.

Die Sammelschiene 42 besteht in der gezeigten Ausführungsform aus drei Schienen, nämlich einer Lastsicherungsschiene, einer Verbindung zu den Entkopplungsdioden 34 sowie einem Rückleiter. Des Weiteren ist der Sammelschiene 42 ein Shunt-Widerstand zur Strommessung zugeordnet.

Es können die rückseitig vorgesehenen Lastanschlüsse 22 ebenfalls als Steckkontakte ausgebildet sein, an denen die entsprechenden Lasten bzw. Lastgruppen angeschlossen werden können.

In der Figur 6 ist ein Einschubwandler 26 als Blockschaltbild dargestellt, insbesondere die galvanische Trennung durch einen Übertrager.

Der Einschubwandler 26 kann als lüfterloser Halbbrückengegentaktwandler mit integrierter Leistungsfaktorkorrektur und Einschaltstrombegrenzung ausgeführt sein.

Der Einschubwandler 26 hat eine regressive lastabhängige Kennlinie, sodass ein entlasteter Einschubwandler 26 immer mehr Last übernehmen wird, wobei dann jedoch die Ausgangsspannung leicht absinkt, sodass sich die Last im Versorgungssystem 10 gleichmäßig verteilt.

Insofern ist eine übergeordnete Steuerung bzw. programmierbare Bauteile nicht notwendig, um die Lastverteilung mit dem Versorgungssystem 10 zu gewährleisten.

Es ist folglich eine hohe Netzverträglichkeit sichergestellt sowie eine Lastaufteilung ohne übergeordnete Steuerung.

Dem Einschubwandler 26 kann zudem eine Spannungs- bzw. Stromanzeige 44 zugeordnet sein, die beispielsweise an der Vorderseite des Einschubwandlers 26 angeordnet ist.

Zusätzlich kann auf der Schranktür des Schaltschrankes 12 eine oder mehrere Spannungs- bzw. Stromanzeige(n) angebracht sein, die einer oder mehrerer Einschubwandlereinheit(en) 20 zugeordnet sind.

Darüber hinaus umfasst die Einschubwandlereinheit 20 eine Überwachungseinheit 46, über die ein Kurzschluss, eine Überspannung und/oder eine Unterspannung überwacht bzw. erkannt werden kann, insbesondere eingangsseitig eine Überspannung und/oder eine Unterspannung und/oder ausgangsseitig ein Kurzschluss, eine Überspannung und/oder eine Unterspannung.

Dabei kann auf externe Sollwerte für den Ausgangsstrom bzw. die Ausgangsspannung zurückgegriffen werden.

Auch können weitere Ausgangssignale über die die Einschubwandlereinheit 20 ausgegeben werden, die allgemein als Fehlersignale, Sicherungsfallsignale bzw. Türüberwachungssignale bezeichnet werden können.

Aufgrund des modular aufgebauten Leittechnikstromversorgungssystems 10 ist es möglich, unterschiedliche Betriebsmodi mit dem Leittechnikstromversorgungssystem 10 zu realisieren, sodass beispielsweise die vier Einschubwandlereinheiten 20 derart miteinander verknüpft werden können, insbesondere über ihre Sammelschienen 42, dass eine Zusammenführung der elektrischen Stromversorgung möglich ist, was einen Gesamtstrom von bis zu 720 A zur Folge hat, da pro Einschubwandlereinheit 20 bis zu 180 A geliefert werden können.

Es kann vorgesehen sein, dass die Lastsicherungsschiene der Sammelschiene 42 sowie die Verbindungschiene zu den Entkopplungsdioden 34 für die letzte der vier Einschubwandlereinheiten 20 mit einer Kupferbrücke verbunden sind, sodass der Strom von der Verbindungschiene zur Lastsicherungsschiene umgeleitet wird. Dann kann über den Shunt-Widerstand der gesamte Summenstrom des Leittechnikstromversorgungssystems 10 gemessen werden, also der Summenstrom der im Schaltschrank 12 untergebrachten elektronischen Komponenten.

Optional kann jede Einschubwandlereinheit 20 mit einem Shunt-Wiederstand ausgeführt sein.

In einem anderen Betriebsmodus können die einzelnen Einschubwandlereinheiten 20 bzw. die Etagen 18 auch galvanisch voneinander getrennt sein, sodass sich eine viersträngige Versorgung bzw. ein viersträngiges Leittechnikstromversorgungssystem 10 ergibt. Hierüber lassen sich die Funktions- bzw. Sicherheitsklassen und/oder die gewünschte Redundanz sicherstellen, die bei der Versorgung eines Kernkraftwerks gewünscht ist.

Generell sind demnach die vertikal verlaufenden Sammelschienen 42 der einzelnen Einschubwandlereinheiten 20 unterteilbar, sodass Trennverbinder oder ähnliches vorgesehen sein können.

Das Leittechnikstromversorgungssystem 10 weist somit eine teilbare Verteilung auf, die aufgrund der einzelnen Sammelschienen 42 der Einschubwandlereinheiten 20 ausgebildet ist, die voneinander getrennt bzw. miteinander verknüpft werden können.

Die verwendeten Einschubwandlern26 können AC/DC, DC/DC bzw. DC/AC Wandler umfassen, mit denen eine Wandlung von 230/400 V AC oder 220 V DC auf 24 V Gleichspannung, 220 V Gleichspannung oder 230 V/400 V Wechselspannung realisiert werden können.

Die entsprechenden Systeme, die üblicherweise in mehreren Schaltschränken vorgesehen waren, lassen sich nun in dem einzigen Schaltschrank 12 implementieren, da die jeweiligen Einschübe 18 und die darin aufgenommenen Einschubwandlereinheiten 20 voneinander separat und galvanisch getrennt sein können, sofern dies gewünscht ist.

Es kann aber auch - aufgrund der modularen Plattform - des Leittechnikstromversorgungssystems 10, insbesondere des Schaltschranks 12, vorgesehen sein, dass die einzelnen Einschubwandlereinheiten 20 über ihre Sammelschienen 42 miteinander elektrisch verbunden sind, sodass beispielsweise ein Gesamtausgangsstrom bereitgestellt wird, der entsprechend höher ist.

Aufgrund des modularen Aufbaus des Leittechnikstromversorgungssystems 10 lassen sich auch einzelne Etagen 18 nicht mit einer Einschubwandlereinheit 20 bestücken, sodass kundenspezifisch andere Betriebsmittel im Schaltschrank 12 untergebracht sind.

Der Zusammenbau des Leittechnikstromversorgungssystems 10 erleichtert sich, da die Einschubwandlereinheiten 20 vorkonfektioniert sein können, sodass sie nur noch aus dem Lager entnommen und in die vorgesehenen Etagen 18 eingesetzt werden müssen. Die jeweiligen Fertigungszeiten verkürzen sich daher entsprechend.

Generell kann das Leittechnikstromversorgungssystem 10 einen elektrischen Zwischenspeicher umfassen, beispielsweise in Form einer Batterie. Das Leittechnikstromversorgungssystem 10 ist ausgebildet, die Batterie laden zu können, wozu eine erhöhte Ausgangsspannung ausgegeben werden kann, zum Beispiel 31 V bei einem 24 V System.

Über die Batterie lässt sich eine unterbrechungsfreie Stromversorgung gewährleisten.

Der Schaltschrank 12 kann Abmessungen aufweisen, die in etwa 40 cm tief und 90 cm breit ist.

Insofern ist ein kompakter Schaltschrank 12 geschaffen, der ein Schaltschrankgehäuse umfasst, in dem sämtliche Komponenten des Leittechnikstromversorgungssystems 10 untergebracht sind.

## Patentansprüche

1. Modular aufgebaute Einschubwandlereinheit (20) für einen Schaltschrank (12) eines Leittechnikstromversorgungssystems (10) eines Kernkraftwerks, wobei die Einschubwandlereinheit (20) einen Rahmen (28), wenigstens eine Sammelschiene (42), eine Gruppe von Sicherungen (38) und eine Gruppe von Lastklemmen (22) umfasst, wobei die Einschubwandlereinheit (20) dazu eingerichtet ist, in den Schaltschrank (12) eingesetzt und in diesem befestigt zu werden, und wobei die im Schaltschrank eingesetzte Einschubwandlereinheit (20) dazu eingerichtet ist, dass ein Einschubwandler (26) oder mehrere Einschubwandler (26) in diese Einschubwandlereinheit (20) eingeschoben werden.

2. Einschubwandlereinheit (20) nach Anspruch 1, **dadurch gekennzeichnet, dass** wenigstens ein galvanisch getrennter Einschubwandler (26) vorgesehen ist, insbesondere wobei der wenigstens eine Einschubwandler (26) eine belastungsabhängige regressive Kennlinie hat.

3. Einschubwandlereinheit (20) nach Anspruch 2, **dadurch gekennzeichnet, dass** der Ausgang der Einschubwandler (26) durch Steckkontakte ausgebildet ist.

4. Einschubwandlereinheit (20) nach einem der vorhergehenden Ansprüche, **dadurch gekennzeichnet, dass** die Sammelschiene (42) mehrteilig ausgebildet ist, insbesondere dreiteilig ausgebildet ist.

5. Einschubwandlereinheit (20) nach einem der vorhergehenden Ansprüche, **dadurch gekennzeichnet, dass** die Einschubwandlereinheit (20) drei galvanisch getrennte Einschubwandler (26) umfasst.

6. Einschubwandlereinheit (20) nach einem der vorhergehenden Ansprüche, **dadurch gekennzeichnet, dass** die Einschubwandlereinheit (20) ein Luftleitblech (32) und/oder eine Entkopplungsdiode (34) umfasst, insbesondere wobei die Entkopplungsdiode (34) mit dem Luftleitblech (32) thermisch gekoppelt ist.

7. Einschubwandlereinheit (20) nach einem der vorhergehenden Ansprüche, **dadurch gekennzeichnet, dass** die Einschubwandlereinheit (20) mindestens eine Lüfterbaugruppe (30) aufweist, insbesondere wobei die Lüfterbaugruppe (30) separat entnehmbar und/oder adaptiv geregelt ist und/oder einen Temperaturfühler umfasst.

8. Einschubwandlereinheit (20) nach einem der vorhergehenden Ansprüche, **dadurch gekennzeichnet, dass** die Einschubwandlereinheit (20) eine Sicherungseinheit (36) umfasst, wobei die Sicherungseinheit die Sicherungen (38) umfasst, die zur elektrischen Absicherung dienen, insbesondere wobei die Lastklemme (22) und/oder die Sammelschiene (42) an der Sicherungseinheit (36) angeordnet sind bzw. ist.

9. Einschubwandlereinheit (20) nach einem der vorhergehenden Ansprüche, **dadurch gekennzeichnet, dass** die Einschubwandlereinheit (20) eine Überwachungseinheit (46) umfasst, die eingerichtet ist, einen Kurzschluss, eine Überspannung und/oder eine Unterspannung zu erkennen, insbesondere wobei die Überwachungseinheit (46) eingangsseitig eine Überspannung und/oder eine Unterspannung und ausgangsseitig einen Kurzschluss, eine Überspannung und/oder eine Unterspannung überwacht.

10. Leittechnikstromversorgungssystem (10) für ein Kernkraftwerk, mit einem Schaltschrank (12), der wenigstens eine elektrische Einspeisung (16), wenigstens einen Lastanschluss (22) und zumindest eine modular aufgebaute Einschubwandlereinheit (20) umfasst, wobei die wenigstens eine Einschubwandlereinheit (20) mit einem Einschubwandler (26) oder mehreren Einschubwandlern (26) bestückt ist, wobei die zumindest eine modular aufgebaute Einschubwandlereinheit (20) eine Einschubwandlereinheit (20) nach einem der Ansprüche 1 bis 9 ist.

11. Leittechnikstromversorgungssystem (10) nach Anspruch 10, **dadurch gekennzeichnet, dass** im Schaltschrank (12) bis zu vier Einspeisungen (16), bis zu vier Gruppen von Lastanschlüssen (22) und/oder bis zu vier modular aufgebaute Einschubwandlereinheiten (20) vorhanden sind.

12. Leittechnikstromversorgungssystem (10) nach Anspruch 10 oder 11, **dadurch gekennzeichnet, dass** der Schaltschrank (12) einen Kabelkanalaufnahmeraum (24) und/oder eine Schaltschranktür aufweist, an der eine Spannungs- und/oder Stromanzeige (44) vorgesehen ist.

13. Leittechnikstromversorgungssystem (10) nach einem der Ansprüche 10 bis 12, **dadurch gekennzeichnet, dass** wenigstens ein elektrischer Zwischenspeicher vorgesehen ist, insbesondere eine Batterie.

14. Leittechnikstromversorgungssystem (10) nach einem der Ansprüche 10 bis 13, **dadurch gekennzeichnet, dass** das Leittechnikstromversorgungssystem (10) Teil einer mehrsträngigen Notstromanlage eines Kernkraftwerks ist.

15. Leittechnikstromversorgungssystem (10) nach einem der Ansprüche 10 bis 14, **dadurch gekennzeichnet, dass** wenigstens zwei modular aufgebaute Einschubwandlereinheiten (20) vorgesehen sind, die in einem ersten Betriebsmodus des Versorgungssystems (10) galvanisch getrennt voneinander sind und in einem zweiten Betriebsmodus des Versorgungssystems (10) elektrisch miteinander verbunden sind.

## Claims

1. A modularly constructed plug-in converter unit (20) for a switch cabinet (12) of a control technology power supply system (10) of a nuclear power plant, wherein the plug-in converter unit (20) comprises a frame (28), at least one busbar (42), a group of fuses (38) and a group of load terminals (22), wherein the plug-in converter unit (20) is configured to be inserted into the switch cabinet (12) and to be fastened therein, and wherein the plug-in converter unit (20), being inserted in the switch cabinet, is arranged such that one plug-in converter (26) or several plug-in converters (26) are inserted into this plug-in converter unit (20).

2. The plug-in converter unit (20) according to claim 1, **characterized in that** at least one galvanically separated plug-in converter (26) is provided, in particular, wherein the at least one plug-in converter (26) has a load-dependent regressive characteristic curve.

3. The plug-in converter unit (20) according to claim 2, **characterized in that** the output of the plug-in converter (26) is formed by plug contacts.

4. The plug-in converter unit (20) according to any one of the preceding claims, **characterized in that** the busbar (42) is formed in multiple parts, in particular, is formed in three parts.

5. The plug-in converter unit (20) according to any one of the preceding claims, **characterized in that** the plug-in converter unit (20) comprises three galvanically separated plug-in converters (26).

6. The plug-in converter unit (20) according to any one of the preceding claims, **characterized in that** the plug-in converter unit (20) comprises an air guide plate (32) and/or a decoupling diode (34), in particular, wherein the decoupling diode (34) is thermally coupled with the air guide plate (32).

7. The plug-in converter unit (20) according to any one of the preceding claims, **characterized in that** the plug-in converter unit (20) has at least one fan assembly (30), in particular, wherein the fan assembly (30) is separately removable and/or adaptively regulated and/or comprises a temperature sensor.

8. The plug-in converter unit (20) according to any one of the preceding claims, **characterized in that** the plug-in converter unit (20) comprises a fuse unit (36), wherein the fuse unit comprises the fuses (38) which serve for electrical protection, in particular, wherein the load terminal (22) and/or the busbar (42) are or is arranged on the fuse unit (36).

9. The plug-in converter unit (20) according to any one of the preceding claims, **characterized in that** the plug-in converter unit (20) comprises a monitoring unit (46), which is configured to detect a short circuit, an overvoltage and/or an undervoltage, in particular, wherein the monitoring unit (46) monitors an overvoltage and/or an undervoltage on the input side and a short circuit, an overvoltage and/or an undervoltage on the output side.

10. A control technology power supply system (10) for a nuclear power plant, having a switch cabinet (12), which comprises at least one electrical feed (16), at least one load connection (22) and at least one modularly constructed plug-in converter unit (20), wherein the at least one plug-in converter unit (20) is equipped with one plug-in converter (26) or a plurality of plug-in converters (26), wherein the at least one modularly constructed plug-in converter unit (20) is a plug-in converter unit (20) according to one of claims 1 to 9.

11. The control technology power supply system (10) according to claim 10, **characterized in that** there are up to four feeds (16), up to four groups of load connections (22) and/or up to four modularly constructed plug-in converter units (20) in the switch cabinet (12).

12. The control technology power supply system (10) according to claim 10 or 11, **characterized in that** the switch cabinet (12) has a cable channel accommodating space (24) and/or a switch cabinet door, on which a voltage- and/or current display (44) is provided.

13. The control technology power supply system (10) according to any one of claims 10 to 12, **characterized in that** at least one electrical intermediate storage is provided, in particular, a battery.

14. The control technology power supply system (10) according to any one of claims 10 to 13, **characterized in that** the control technology power supply system (10) is part of a multi-stranded emergency power system of a nuclear power plant.

15. The control technology power supply system (10) according to any one of claims 10 to 14, **characterized in that** at least two modularly constructed plug-in converter units (20) are provided, which are galvanically separated from one another in a first operating mode of the supply system (10) and are electrically connected to one another in a second operating mode of the supply system (10).

## Revendications

1. Unité de conversion encastrable (20) de conception modulaire pour une armoire de commande (12) d'un système d'alimentation électrique de contrôle-commande (10) d'une centrale nucléaire, dans laquelle l'unité de conversion encastrable (20) comprend un cadre (28), au moins un jeu de barres (42), un groupe de fusibles (38) et un groupe de bornes de charge (22), dans laquelle l'unité de conversion encastrable (20) est conçue pour être insérée et fixée dans l'armoire de commande (12), et dans laquelle l'unité de conversion encastrable (20) insérée dans l'armoire de commande est conçue pour qu'un convertisseur encastrable (26) ou plusieurs convertisseurs encastrables (26) soient insérés dans cette unité de conversion encastrable (20).

2. Unité de conversion encastrable (20) selon la revendication 1, **caractérisée en ce qu'**il est prévu au moins un convertisseur encastrable (26) séparé galvaniquement, en particulier dans laquelle l'au moins un convertisseur encastrable (26) a une caractéristique régressive dépendant de la charge.

3. Unité de conversion encastrable (20) selon la revendication 2, **caractérisée en ce que** la sortie des convertisseurs encastrables (26) est formée par des fiches de contact.

4. Unité de conversion encastrable (20) selon l'une des revendications précédentes, **caractérisée en ce que** le jeu de barres (42) est formé de plusieurs parties, en particulier de trois parties.

5. Unité de conversion encastrable (20) selon l'une des revendications précédentes, **caractérisée en ce que** l'unité de conversion encastrable (20) comprend trois convertisseurs encastrables (26) séparés galvaniquement.

6. Unité de conversion encastrable (20) selon l'une des revendications précédentes, **caractérisée en ce que** l'unité de conversion encastrable (20) comprend un déflecteur d'air (32) et/ou une diode de découplage (34), en particulier dans laquelle la diode de découplage (34) est couplée thermiquement au déflecteur d'air (32).

7. Unité de conversion encastrable (20) selon l'une des revendications précédentes, **caractérisée en ce que** l'unité de conversion encastrable (20) présente au moins un module de ventilateur (30), en particulier dans laquelle le module de ventilateur (30) peut être retiré séparément et/ou est régulé de manière adaptative et/ou comprend un capteur de température.

8. Unité de conversion encastrable (20) selon l'une des revendications précédentes, **caractérisée en ce que** l'unité de conversion encastrable (20) comprend une unité de fusibles (36), dans laquelle l'unité de fusibles comprend les fusibles (38) qui servent à la protection électrique, en particulier dans laquelle la borne de charge (22) et/ou le jeu de barres (42) sont disposés au niveau de l'unité de fusibles (36).

9. Unité de conversion encastrable (20) selon l'une des revendications précédentes, **caractérisée en ce que** l'unité de conversion encastrable (20) comprend une unité de contrôle (46) qui est conçue pour détecter un court-circuit, une surtension et/ou une sous-tension, en particulier dans laquelle l'unité de contrôle (46) contrôle du côté de l'entrée une surtension et/ou une sous-tension et du côté de la sortie un court-circuit, une surtension et/ou une sous-tension.

10. Système d'alimentation électrique de contrôle-commande (10) pour une centrale nucléaire, comprenant une armoire de commande (12) qui comprend au moins une alimentation électrique (16), au moins une interface de charge (22) et au moins une unité de conversion encastrable (20) de conception modulaire, dans lequel l'au moins une unité de conversion encastrable (20) est équipée d'un convertisseur encastrable (26) ou de plusieurs convertisseurs encastrables (26), dans lequel die l'au moins une unité de conversion encastrable (20) de conception modulaire est une unité de conversion encastrable (20) selon l'une des revendications 1 à 9.

11. Système d'alimentation électrique de contrôle-commande (10) selon la revendication 10, **caractérisé en ce que** l'armoire de commande (12) comporte jusqu'à quatre alimentations (16), jusqu'à quatre groupes d'interfaces de charge (22) et/ou jusqu'à quatre unités de conversion encastrables (20) de conception modulaire.

12. Système d'alimentation électrique de contrôle-commande (10) selon la revendication 10 ou 11, **caractérisé en ce que** l'armoire de commande (12) présente un logement de conduit de câbles (24) et/ou une porte d'armoire de commande sur laquelle est prévu un indicateur de tension et/ou de courant (44).

13. Système d'alimentation électrique de contrôle-commande (10) selon l'une des revendications 10 à 12, **caractérisé en ce qu'**il est prévu au moins un accumulateur électrique intermédiaire, en particulier une batterie.

14. Système d'alimentation électrique de contrôle-commande (10) selon l'une des revendications 10 à 13, **caractérisé en ce que** le système de commande d'alimentation électrique (10) fait partie d'une installation électrique de secours à plusieurs lignes d'une centrale nucléaire.

15. Système d'alimentation électrique de contrôle-commande (10) selon l'une des revendications 10 à 14, **caractérisé en ce qu'**il est prévu au moins deux unités de conversion encastrables (20) de conception modulaire qui sont séparées galvaniquement l'une de l'autre dans un premier mode de fonctionnement du système d'alimentation (10) et qui sont reliées électriquement entre elles dans un deuxième mode de fonctionnement du système d'alimentation (10).
